# EUROPÄISCHE PATENTSCHRIFT

(11) **EP 2 994 512 B1**
(45) Veröffentlichungstag und Bekanntmachung des Hinweises auf die Patenterteilung: **18.08.2021**
(21) Anmeldenummer: 14729576.0
(22) Anmeldetag: 12.05.2014
(51) Int. Cl.: C09J 163/00

(54) **ZUSAMMENSETZUNG ZUR HERSTELLUNG VON SPACHTELMASSEN UND VERFAHREN ZUR HERSTELLUNG UND VERARBEITUNG DER SPACHTELMASSEN**
COMPOSITION FOR PRODUCING FILLERS AND METHOD FOR PRODUCING AND PROCESSING THE FILLERS
COMPOSITION DESTINÉE À LA PRODUCTION DE MASTICS ET PROCÉDÉ DE PRODUCTION ET DE TRAITEMENT DES MASTICS

(30) Priorität: 10.05.2013 DE 102013007917
(43) Veröffentlichungstag der Anmeldung: 16.03.2016
(73) Patentinhaber: Mankiewicz Gebr. & Co. GmbH & Co. KG, 21107 Hamburg (DE)
(72) Erfinder: WEHNER, Jochen, 21075 Hamburg (DE); BUENING, Jens, 21391 Reppenstedt (DE); VOSS, Martina, 21465 Reinbek (DE)
(86) Internationale Anmeldenummer: PCT/DE2014/000240
(87) Internationale Veröffentlichungsnummer: WO 2014/180463

(56) Entgegenhaltungen:
- EP-A2- 0 085 379
- WO-A1-2012/035520
- WO-A2-02/16519
- US-A- 5 571 312
- US-B1- 6 733 472

## Beschreibung

Die Erfindung betrifft Zusammensetzungen zur Herstellung von Spachtelmassen, welche zur Verwendung in maschinellen Applikationsprozessen geeignet sind. Die Erfindung betrifft vor allem Spachtelmassen zur Vorbereitung von Oberflächen zur Lackierung, insbesondere zur Hochglanz- oder "Wet-Look"-Lackierung von Schiffsrümpfen und Schiffsaufbauten im Yachtbau. Weiterhin betrifft die Erfindung Verfahren zur Herstellung und Verarbeitung dieser Spachtelmassen.

Im Yachtbau sind hochglänzende, spiegelnde Außenoberflächen der Aufbauten und des Rumpfs oberhalb der Wasserlinie besonders erwünscht. Um dies zu erreichen, müssen die Untergründe, auf denen die entsprechenden hochglänzenden Beschichtungssysteme appliziert werden, gleichmäßig und glatt sein. Größere Schiffe ab einer Länge von etwa 50 Metern werden in der Regel aus Stahlblechen hergestellt, so dass sie typische Bearbeitungsspuren wie Schweißnähte aufweisen. Üblicherweise wird der gesamte Schiffskörper inklusive der Aufbauten vor einer Lackierung von Hand bearbeitet, um eine einheitliche, fehlerfreie Oberfläche zu erreichen. Hierzu werden Unebenheiten durch Auftragen einer Spachtelmasse oder eines Spachtels gefüllt. Die Oberfläche wird nach Aushärtung des Spachtels glatt geschliffen. Diese Arbeitsschritte werden solange wiederholt bis die erforderliche Güte der Oberfläche erreicht ist. Die Stärke der Spachtelschicht hängt von der Rauhigkeit der Oberfläche ab. Um die geforderte Gleichmäßigkeit und Glätte zu erreichen, können Spachtelschichten von bis zu mehreren Zentimetern Dicke aufgetragen werden.

Bei diesen Schichtdicken sind besondere Anforderungen zu erfüllen. Um eine Rissbildung in der Spachtelschicht beispielsweise bei Verwindungen des Schiffsrumpfs oder Temperaturschwankungen zu vermeiden, muss der ausgehärtete Spachtel hinreichend elastisch sein. Weiterhin spielt die Dichte des Spachtels eine große Rolle. Die ausgehärteten Spachtel sollten eine vergleichsweise geringe Dichte aufweisen, um bei den eingesetzten Mengen an Spachtelmassen das Gesamtgewicht des Schiffs möglichst wenig zu erhöhen.

Bisher werden zweikomponentige Spachtelmassen auf Basis von Epoxidharzen eingesetzt. Diesen werden Glashohlkugeln als Leichtfüllstoffe zugesetzt, um eine Dichte zwischen 0,5 und 1 g/cm³ zu erreichen. Diese Spachtelmassen können jedoch nicht mit den üblicherweise zur Verarbeitung von zweikomponentigen Systemen eingesetzten Maschinen verarbeitet werden. Die üblichen Verarbeitungsmaschinen pumpen die beiden Komponenten aus ihren jeweiligen Vorratsbehältern in eine Mischkammer, vermischen sie dort und tragen die Mischung dann aus der Maschine aus. Übliche Austragsweisen sind dem Fachmann bekannt und geläufig wie beispielsweise Giessen, Ablegen von Raupen, hydraulisches oder Druckluft unterstütztes Zerstäuben. Die hierbei auf die Spachtelmassen einwirkenden Drucke und Scherkräfte führen zur Zerstörung der Glashohlkugeln. Durch diese Zerstörung wird zum einen die Dichte der Spachtelmasse erhöht, so dass der ausgehärtete Spachtel deutlich dichter wird. Zum anderen verschlechtern sich die mechanischen Eigenschaften beispielsweise die Elastizität des ausgehärteten Spachtels. Daher werden Schiffe bisher in zeitaufwendigen und kostenintensiven Verfahren per Hand bearbeitet.

Aus EP 1103310, die auch als DE 60034646 veröffentlicht wurde, ist ein maschinelles Auftragungsverfahren bekannt, in dem Spachtelmassen gemäß US 5571312 eingesetzt werden. Diese zweikomponentigen Spachtelmassen auf Basis von Epoxidharzen enthalten als Füllstoff unter anderem Keramikhohlkugeln. Diese sind zwar mechanisch hinreichend stabil, dass sie ohne Zerstörung maschinell verarbeitet werden können, sie weisen jedoch eine deutlich höhere Dichte als Glashohlkugeln auf.

Aufgabe der vorliegenden Erfindung ist es daher, verbesserte Spachtelmassen zur Verfügung zu stellen, welche unter Beibehaltung ihrer gewünschten Eigenschaften, die Nachteile der bisher bekannten Spachtelmassen überwinden. Aufgabe ist es insbesondere, Spachtelmassen, welche maschinell verarbeitbar und applizierbar sind, und entsprechend geeignete Verarbeitungsverfahren zur Verfügung zu stellen.

Gelöst wird diese Aufgabe durch die Verwendung von Spachtelmassen gemäß Hauptanspruch. Die der Erfindung zugrunde liegende Aufgabe wird weiterhin gelöst durch durch ein Verarbeitungsverfahren gemäß Anspruch 9 sowie durch eine Zusammensetzung gemäß Anspruch 14. Weitere Ausführungsformen der Erfindung werden in den Unteransprüchen und der Beschreibung angegeben.

Als Spachtel oder Spachtelmassen werden im Folgenden meist pigmentierte, hochgefüllte Beschichtungsstoffe bezeichnet, die auf Untergründen aus Metall-, Holz- oder Faserverbundwerkstoffen zum Ausgleichen von Unebenheiten der Oberflächen eingesetzt werden. Die erfindungsgemäßen Spachtelmassen enthalten eine Bindemittelkomponente und eine Härterkomponente, welche erst kurz vor der Verarbeitung miteinander vermischt werden. Die Bindemittelkomponente weist dabei ein oder mehrere Epoxidharze auf.

Geeignete Epoxidharze sind Glycidylether des Bisphenol A, Glycidylether des Bisphenol F, Glycidylether des Bisphenol A und F, Epoxid-Novolak-Harze oder niederviskose Epoxidharze wie z.B. Mono-, Di- oder Polyglycidylether ein- oder mehrwertiger Alkohole oder Polyole, und deren Gemische. Erfindungsgemäß bevorzugt sind Glycidylether des Bisphenol A, Glycidylether des Bisphenol F, Glycidylether des Bisphenol A und F, Diglycidylether des Hexandiols, Diglycidylether des Butandiols und Monoglycidylether von Alkoholen mit 12 bis 14 Kohlenstoffatomen (C12- bis C14-Alkohole) sowie deren Gemische.

In einer Ausführungsform werden dabei Glycidylether des Bisphenol A, im Folgenden als Bisphenol-A-Harze bezeichnet, eingesetzt in Mengen von 40 bis 95 Gew.-%, bevorzugt 45 bis 90 Gew.-%, besonders bevorzugt 50 bis 85 Gew.-%, ganz besonders bevorzugt 60 bis 80 Gew.-%, insbesondere 70 bis 73 Gew.-%, jeweils bezogen auf die Masse der Bindemittelkomponente. In einer weiteren Ausführungsform werden dabei Glycidylether des Bisphenol F, im Folgenden als Bisphenol-F-Harze bezeichnet, eingesetzt in Mengen von 40 bis 95 Gew.-%, bevorzugt 45 bis 90 Gew.-%, besonders bevorzugt 50 bis 85 Gew.-%, ganz besonders bevorzugt 60 bis 80 Gew.-%, insbesondere 70 bis 73 Gew.-%, jeweils bezogen auf die Masse der Bindemittelkomponente. In einer weiteren Ausführungsform werden dabei Gemische aus Glycidylethern des Bisphenol A und Glycidylethern des Bisphenol F, im Folgenden als Bisphenol-A/F-Harze bezeichnet, eingesetzt in Mengen von 40 bis 95 Gew.-%, bevorzugt 45 bis 90 Gew.-%, besonders bevorzugt 50 bis 85 Gew.-%, ganz besonders bevorzugt 60 bis 80 Gew.-%, insbesondere 70 bis 73 Gew.-%, jeweils bezogen auf die Masse der Bindemittelkomponente.

In einer weiteren Ausführungsform können zusätzlich niederviskose Epoxidharze eingesetzt in Mengen von bis zu 95 Gew.-%, bevorzugt 5 bis 40 Gew.-%, besonders bevorzugt 8 bis 30 Gew.-%, ganz besonders bevorzugt 10 bis 20 Gew.-%, insbesondere 11 bis 14 Gew.-%, jeweils bezogen auf die Masse der Bindemittelkomponente.

Erfindungsgemäß werden in der Härterkomponente ein oder mehrere NH-gruppenhaltige Verbindungen eingesetzt, wobei diese so gewählt werden, dass die Spachtelmasse bei Raumtemperatur vollständig abreagiert bzw. durchhärtet. Auf diese Weise wird eine Nachreaktion bei Wärme oder über einen längeren Zeitraum verhindert. Bei nicht vollständig ausgehärteten Spachtelmassen führt eine spätere Nachhärtung zur Erhöhung der Glasübergangstemperatur T_{G}, wodurch die Verformbarkeit des ausgehärteten Spachtels reduziert wird. Die unterschiedlichen thermischen Ausdehungskoeffizienten des Substrats, in der Regel Stahl, und des Spachtels bewirken mechanische Spannungen an der Grenzfläche zwischen ausgehärteten Spachtel und Untergrund. Auch schrumpft die Spachtelmasse während des Aushärtens, ein Vorgang, der üblicherweise als Reaktionsschrumpf bezeichnet wird. Als Folge der erhöhten Glasübergangstemperatur steigen so die mechanischen Spannungen an der Grenzfläche zwischen Spachtel und Untergrund deutlich an.

Erfindungsgemäß als Härter geeignete NH-gruppenhaltige Verbindungen sind aliphatische und cycloaliphatische Amine, Amide, Amidoamine und aromatische Amine sowie deren Gemische. Bevorzugt sind aliphatische, cycloaliphatische Amine, Amidoamine und deren Gemische. Dabei werden die NH-gruppenhaltigen Verbindungen eingesetzt in Mengen von 5 bis 70 Gew.-%, bevorzugt 7 bis 50 Gew.-%, besonders bevorzugt 10 bis 45 Gew.-%, ganz besonders bevorzugt 11 bis 40 Gew.-%, insbesondere 13 bis 30 Gew.-%, jeweils bezogen auf die Masse der Härterkomponente.

Bindemittelkomponente und Härterkomponente werden in einem molaren Verhältnis von 0,5 : 1,5, bevorzugt von 0,7 : 1,3, besonders bevorzugt von 0,8 : 1,2, ganz besonders bevorzugt 0,9 : 1,1, insbesondere 0,98 : 1,02, eingesetzt bezogen auf das Verhältnis von Epoxidgruppen zu aktiven Wasserstoffen der NH-Gruppen. In einer weiteren Ausführungsform werden Bindemittel- und Härterkomponente in einem gravimetrischen Mischungsverhältnis von 2 : 1 bis 0,5 : 1, bevorzugt 1 : 1, eingesetzt. In einer weiteren Ausführungsform werden Bindemittel- und Härterkomponente in einem volumetrischen Mischungsverhältnis von 2 : 1 bis 0,5 : 1, bevorzugt 1 : 1, eingesetzt.

In einer Ausführungsform der vorliegenden Erfindung weist die Zusammensetzung in der Bindemittelkomponente Bisphenol-A-Harz und in der Härterkomponente aliphatische und/oder cycloaliphatische Amine auf. In einer weiteren Ausführungsform weist die erfindungsgemäße Zusammensetzung in der Bindemittelkomponente Bisphenol-A-Harz und in der Härterkomponente Amidoamine auf. In einer weiteren Ausführungsform weist die erfindungsgemäße Zusammensetzung in der Bindemittelkomponente Bisphenol-A-Harz und in der Härterkomponente aliphatische und/oder cycloaliphatische Amine sowie Amidoamine auf.

In einer Ausführungsform der vorliegenden Erfindung weist die Zusammensetzung in der Bindemittelkomponente Bisphenol-A-Harz sowie Diglycidylether des Hexandiols und in der Härterkomponente aliphatische und/oder cycloaliphatische Amine auf. In einer weiteren Ausführungsform weist die erfindungsgemäße Zusammensetzung in der Bindemittelkomponente Bisphenol-A-Harz sowie Diglycidylether des Hexandiols und in der Härterkomponente Amidoamine auf. In einer weiteren Ausführungsform weist die erfindungsgemäße Zusammensetzung in der Bindemittelkomponente Bisphenol-A-Harz sowie Diglycidylether des Hexandiols und in der Härterkomponente aliphatische und/oder cycloaliphatische Amine sowie Amidoamine auf.

In einer Ausführungsform der vorliegenden Erfindung weist die Zusammensetzung in der Bindemittelkomponente Bisphenol-A-Harz sowie Diglycidylether des Butandiols und in der Härterkomponente aliphatische und/oder cycloaliphatische Amine auf. In einer weiteren Ausführungsform weist die erfindungsgemäße Zusammensetzung in der Bindemittelkomponente Bisphenol-A-Harz sowie Diglycidylether des Butandiols und in der Härterkomponente Amidoamine auf. In einer weiteren Ausführungsform weist die erfindungsgemäße Zusammensetzung in der Bindemittelkomponente Bisphenol-A-Harz sowie Diglycidylether des Butandiols und in der Härterkomponente aliphatische und/oder cycloaliphatische Amine sowie Amidoamine auf.

In einer Ausführungsform der vorliegenden Erfindung weist die Zusammensetzung in der Bindemittelkomponente Bisphenol-A-Harz sowie Monoglycidylether von C12- bis C14-Alkoholen und in der Härterkomponente aliphatische und/oder cycloaliphatische Amine auf. In einer weiteren Ausführungsform weist die erfindungsgemäße Zusammensetzung in der Bindemittelkomponente Bisphenol-A-Harz sowie Monoglycidylether von C12- bis C14-Alkoholen und in der Härterkomponente Amidoamine auf. In einer weiteren Ausführungsform weist die erfindungsgemäße Zusammensetzung in der Bindemittelkomponente Bisphenol-A-Harz sowie Monoglycidylether von C12- bis C14-Alkoholen und in der Härterkomponente aliphatische und/oder cycloaliphatische Amine sowie Amidoamine auf.

In einer Ausführungsform der vorliegenden Erfindung weist die Zusammensetzung in der Bindemittelkomponente Bisphenol-F-Harz und in der Härterkomponente aliphatische und/oder cycloaliphatische Amine auf. In einer weiteren Ausführungsform weist die erfindungsgemäße Zusammensetzung in der Bindemittelkomponente Bisphenol-F-Harz und in der Härterkomponente Amidoamine auf. In einer weiteren Ausführungsform weist die erfindungsgemäße Zusammensetzung in der Bindemittelkomponente Bisphenol-F-Harz und in der Härterkomponente aliphatische und/oder cycloaliphatische Amine sowie Amidoamine auf.

In einer Ausführungsform der vorliegenden Erfindung weist die Zusammensetzung in der Bindemittelkomponente Bisphenol-F-Harz sowie Diglycidylether des Hexandiols und in der Härterkomponente aliphatische und/oder cycloaliphatische Amine auf. In einer weiteren Ausführungsform weist die erfindungsgemäße Zusammensetzung in der Bindemittelkomponente Bisphenol-F-Harz sowie Diglycidylether des Hexandiols und in der Härterkomponente Amidoamine auf. In einer weiteren Ausführungsform weist die erfindungsgemäße Zusammensetzung in der Bindemittelkomponente Bisphenol-F-Harz sowie Diglycidylether des Hexandiols und in der Härterkomponente aliphatische und/oder cycloaliphatische Amine sowie Amidoamine auf.

In einer Ausführungsform der vorliegenden Erfindung weist die Zusammensetzung in der Bindemittelkomponente Bisphenol-F-Harz sowie Diglycidylether des Butandiols und in der Härterkomponente aliphatische und/oder cycloaliphatische Amine auf. In einer weiteren Ausführungsform weist die erfindungsgemäße Zusammensetzung in der Bindemittelkomponente Bisphenol-F-Harz sowie Diglycidylether des Butandiols und in der Härterkomponente Amidoamine auf. In einer weiteren Ausführungsform weist die erfindungsgemäße Zusammensetzung in der Bindemittelkomponente Bisphenol-F-Harz sowie Diglycidylether des Butandiols und in der Härterkomponente aliphatische und/oder cycloaliphatische Amine sowie Amidoamine auf.

In einer Ausführungsform der vorliegenden Erfindung weist die Zusammensetzung in der Bindemittelkomponente Bisphenol-F-Harz sowie Monoglycidylether von C12- bis C14-Alkoholen und in der Härterkomponente aliphatische und/oder cycloaliphatische Amine auf. In einer weiteren Ausführungsform weist die erfindungsgemäße Zusammensetzung in der Bindemittelkomponente Bisphenol-F-Harz sowie Monoglycidylether von C12- bis C14-Alkoholen und in der Härterkomponente Amidoamine auf. In einer weiteren Ausführungsform weist die erfindungsgemäße Zusammensetzung in der Bindemittelkomponente Bisphenol-F-Harz sowie Monoglycidylether von C12- bis C14-Alkoholen und in der Härterkomponente aliphatische und/oder cycloaliphatische Amine sowie Amidoamine auf.

In einer Ausführungsform der vorliegenden Erfindung weist die Zusammensetzung in der Bindemittelkomponente Bisphenol-A/F-Harze und in der Härterkomponente aliphatische und/oder cycloaliphatische Amine auf. In einer weiteren Ausführungsform weist die erfindungsgemäße Zusammensetzung in der Bindemittelkomponente Bisphenol-A/F-Harze und in der Härterkomponente Amidoamine auf. In einer weiteren Ausführungsform weist die erfindungsgemäße Zusammensetzung in der Bindemittelkomponente Bisphenol-A/F-Harze und in der Härterkomponente aliphatische und/oder cycloaliphatische Amine sowie Amidoamine auf.

In einer Ausführungsform der vorliegenden Erfindung weist die Zusammensetzung in der Bindemittelkomponente Bisphenol-A/F-Harze sowie Diglycidylether des Hexandiols und in der Härterkomponente aliphatische und/oder cycloaliphatische Amine auf. In einer weiteren Ausführungsform weist die erfindungsgemäße Zusammensetzung in der Bindemittelkomponente Bisphenol-A/F-Harze sowie Diglycidylether des Hexandiols und in der Härterkomponente Amidoamine auf. In einer weiteren Ausführungsform weist die erfindungsgemäße Zusammensetzung in der Bindemittelkomponente Bisphenol-A/F-Harze sowie Diglycidylether des Hexandiols und in der Härterkomponente aliphatische und/oder cycloaliphatische Amine sowie Amidoamine auf.

In einer Ausführungsform der vorliegenden Erfindung weist die Zusammensetzung in der Bindemittelkomponente Bisphenol-A/F-Harze sowie Diglycidylether des Butandiols und in der Härterkomponente aliphatische und/oder cycloaliphatische Amine auf. In einer weiteren Ausführungsform weist die erfindungsgemäße Zusammensetzung in der Bindemittelkomponente Bisphenol-A/F-Harze sowie Diglycidylether des Butandiols und in der Härterkomponente Amidoamine auf. In einer weiteren Ausführungsform weist die erfindungsgemäße Zusammensetzung in der Bindemittelkomponente Bisphenol-A/F-Harze sowie Diglycidylether des Butandiols und in der Härterkomponente aliphatische und/oder cycloaliphatische Amine sowie Amidoamine Amine auf.

In einer Ausführungsform der vorliegenden Erfindung weist die Zusammensetzung in der Bindemittelkomponente Bisphenol-A/F-Harze sowie Monoglycidylether von C12- bis C14-Alkoholen und in der Härterkomponente aliphatische und/oder cycloaliphatische Amine auf. In einer weiteren Ausführungsform weist die erfindungsgemäße Zusammensetzung in der Bindemittelkomponente Bisphenol-A/F-Harze sowie Monoglycidylether von C12- bis C14-Alkoholen und in der Härterkomponente Amidoamine auf. In einer weiteren Ausführungsform weist die erfindungsgemäße Zusammensetzung in der Bindemittelkomponente Bisphenol-A/F-Harze sowie Monoglycidylether von C12- bis C14-Alkoholen und in der Härterkomponente aliphatische und/oder cycloaliphatische Amine sowie Amidoamine auf.

Die erfindungsgemäßen Zusammensetzungen enthalten weiterhin Kunststoffhohlkörper in Mengen von bis zu 15 Gew.-%, bevorzugt 0,2 bis 12 Gew.-%, besonders bevorzugt 0,4 bis 8 Gew.-%, ganz besonders bevorzugt 0,7 bis 4 Gew.-%, insbesondere 1,5 bis 2 Gew.-%, jeweils bezogen auf die Gesamtmasse der Spachtelmasse. Dabei können die Hohlkörper der Bindemittelkomponente oder der Härterkomponente oder beiden Komponenten zugesetzt werden. Bevorzugt enthalten beide Komponenten Hohlkörper.

Geeignete Hohlkörper sind bevorzugt Hohlkugeln, insbesondere Hohlkugeln mit einem Außendurchmesser von durchschnittlich 20 bis 200 µm, bevorzugt 25 bis 100 µm, besonders bevorzugt von 30 bis 60 µm. Die Maße der Kugeln wurden dabei mit Hilfe der Laserdiffraktion (Klein-Winkel-Laserlicht-Streuung LALLS), einem der üblichen Verfahren zur Bestimmung der Partikelgröße, bestimmt. Die Hohlkugeln weisen weiterhin eine Dichte von 0,005 bis 0,8 g/cm³, bevorzugt 0,01 bis 0,5 g/cm³, besonders bevorzugt 0,02 bis 0,03 g/cm³, auf. Die Dichte der Hohlkugeln wird dabei mit Hilfe eines Zweikammer-Pyknometer-Messgeräts.

Die Dichte der erfindungsgemäßen Spachtelmassen erreicht somit 0,25 bis 1,5 g/cm³, bevorzugt 0,3 bis 1,2 g/cm³, besonders bevorzugt 0,5 bis 1 g/cm³.

Im Unterschied zu den bisher eingesetzten Glashohlkugeln sind die erfindungsgemäß eingesetzten Kunststoffhohlkugeln mechanisch deutlich stabiler. Auf Grund ihrer Kompressibilität und Elastizität sind sie scher- und druckstabil. Werden sie in den Verarbeitungsmaschinen wie zum Beispiel in Förderpumpen oder Zerstäubungsdüsen komprimiert, so werden sie im Unterschied zu Glashohlkugeln, die zerdrückt und zerstört werden, lediglich verformt. Besonders bevorzugt werden Kunststoffhohlkugeln eingesetzt, die sich elastisch verformen, d.h. die Kugeln nehmen bei Entlastung wieder ihre ursprüngliche Form an. Der Spachtel erhält damit nach der maschinellen Applikation die eingestellte Dichte zurück und härtet wie gewünscht aus. Zur Herstellung der erfindungsgemäß eingesetzten Kunststoffhohlkugeln werden thermoplastische Kunststoffe verwendet wie beispielsweise Acrylnitril-Methacrylnitril-Methylmethacrylat-Copolymere oder Acrylnitril-Vinylidenchlorid-Methylmethacrylat-Copolymere.

Ein weiterer Vorteil der erfindungsgemäßen Spachtelmassen ist ihre bessere Schleifbarkeit. Im Unterschied zu den bisher eingesetzten Glashohlkugeln sind die erfindungsgemäßen Kunststoffhohlkugeln deutlich weicher, so dass weniger Kraft zum Schleifen des gehärteten Spachtels aufgewendet werden muss.

Die erfindungsgemäße Kombination von Bindemittel und Härter führt zu einer erhöhten Elastizität des ausgehärteten Spachtels. Der erfindungsgemäße Zusatz von Kunststoffhohlkugeln führt überraschenderweise nicht nur zu einer verbesserten mechanischen Stabilität der Spachtelmassen sondern zu einer weiteren Zunahme der Elastizität des ausgehärteten Spachtels. Die erfindungsgemäßen Spachtel können daher Ausdehnungsänderungen des Schiffskörpers, wie sie beispielsweise durch Temperaturschwankungen ausgelöst werden, besser folgen und zeigen somit eine deutlich verringerte Neigung zur Rissbildung.

In einer weiteren Ausführungsform weist die erfindungsgemäße Zusammensetzung zusätzlich ein oder mehrere Füllstoffe auf. Die Menge der eingesetzten Füllstoffe hängt ab von der Dichte des Füllstoffs und der gewünschten Steifigkeit der Spachtelmasse. Erfindungsgemäß werden Mengen bis zu 90 Gew.-%, bevorzugt bis zu 80 Gew.-%, besonders bevorzugt bis 40 Gew.-%, jeweils bezogen auf die Gesamtmasse der Spachtelmasse eingesetzt.

Geeignete Füllstoffe sind beispielsweise Talkum, Quarzmehl, Kaolin, Dolomit, Bariumsulfat, Calciumcarbonat, Calcit, Cristobalitmehl, Kieselerde, Wollastonitmehl und deren Gemische. Erfindungsgemäß bevorzugt werden Talkum, Calciumcarbonat, Bariumsulfat, Quarzmehl, Kaolin und/oder Dolomit eingesetzt.

Die erfindungsgemäße Zusammensetzung kann weiterhin ein oder mehrere der dem Fachmann bekannten und geläufigen Pigmente aufweisen. Bevorzugt werden anorganische Pigmente eingesetzt wie beispielsweise Titandioxid Eisenoxide, Eisenhydroxide oder Chromoxide.

Die erfindungsgemäße Zusammensetzung kann weiterhin ein oder mehrere der dem Fachmann bekannten und geläufigen Additive aufweisen wie beispielsweise Wachse, Molekularsieb, Entschäumer, Entlüfter, Rheologieadditive wie hydriertes Rhizinusöl und pyrogene Kieselsäure, Weichmacher wie beispielsweise Kohlenwasserstoffharze oder Benzylalkohol, Dispergieradditive, Beschleuniger, Oberflächenadditive, Verlaufsadditive und Vernetzungsadditive.

In einer bevorzugte Ausführungsform umfassen die erfindungsgemäßen Spachtelmassen eine BindemittelKomponente A und eine Härter-Komponente B, wobei Komponente A
- 40 bis 95 Gew.-% Bisphenolharze
- bis 15 Gew.-% Thixotrophierungsmittel
- bis zu 80 Gew.-% Pigmente
- bis zu 80 Gew.-% Füllstoffe
- bis zu 95 Gew.-% niedrigviskose Epoxidharze, jeweils bezogen auf die Gesamtmasse der Komponente A, enthält und die Komponente B
- 7 bis 50 Gew.-% Amine und/oder Amidoamine
- bis zu 20 Gew.-% Weichmacher
- bis zu 80 Gew.-% Pigmente
- bis zu 80 Gew.-% Füllstoff
- bis zu 15 Gew.-% Thixotrophierungsmittel, jeweils bezogen auf die Gesamtmasse der Komponente B, enthält. Weiterhin enthalten die Spachtelmassen 0,2 bis 12 Gew.-% Kunststoffhohlkugeln bezogen auf die Gesamtmasse der Spachtelmasse, wobei die Hohlkugeln der Komponente A oder B oder beiden Komponenten A und B zugesetzt werden.

Besonders bevorzugt enthält die Komponente A
- 50 bis 85 Gew.-% Bisphenolharze
- 1 bis 10 Gew.-% Thixotrophierungsmittel
- bis zu 60 Gew.-% Pigmente
- bis zu 60 Gew.-% Füllstoffe
- bis zu 50 Gew.-% niedrigviskose Epoxidharze, jeweils bezogen auf die Gesamtmasse der Komponente A, und die Komponente B enthält
- 10 bis 45 Gew.-% Amine und/oder Amidoamine
- bis zu 10 Gew.-% Weichmacher
- bis zu 60 Gew.-% Pigmente
- bis zu 60 Gew.-% Füllstoff
- 1 bis 10 Gew.-% Thixotrophierungsmittel, jeweils bezogen auf die Gesamtmasse der Komponente B. Weiterhin enthalten die Spachtelmassen 0,4 bis 8 Gew.-% Kunststoffhohlkugeln bezogen auf die Gesamtmasse der Spachtelmasse, wobei die Hohlkugeln der Komponente A oder B oder beiden Komponenten A und B zugesetzt werden.

Die erfindungsgemäßen Spachtel sind besonders elastisch, so dass sie bei Bewegungen des Untergrunds kaum Risse ausbilden. Sie sind mechanisch stabil, insbesondere stabil gegen Scherung und Kompression, so dass sie ohne Beeinträchtigungen ihrer Eigenschaften maschinell verarbeitet insbesondere verpumpt, gemischt und appliziert werden können. Weiterhin zeigen sie im Unterschied zu den bekannten Glashohlkugel-haltigen Spachteln eine verbesserte Schleif- und Fräsbarkeit.

Die der Erfindung zugrunde liegende Aufgabe wird auch durch die Verwendung der erfindungsgemäßen Zusammensetzungen in Verarbeitungsverfahren, gelöst, die zumindest einen Verfahrensschritt aufweisen, der mittels einer Maschine ausgeführt wird. Im Folgenden wird unter Verarbeitung der Spachtelmassen die Herstellung durch Dosieren der Bindemittelkomponente und der Härterkomponente, Vermischen der Komponenten zu einer homogenen Masse und die daran anschließende Applikation der Spachtelmasse auf den zu beschichtenden Untergrund verstanden. Die Bindemittelkomponente und Härterkomponente können dabei unterschiedlich eingefärbt sein, um bei der Mischung der beiden Komponenten eine Anzeige für die Homogenität der Mischung zu haben.

In einer besonderen Ausführungsform werden die erfindungsgemäßen Zusammensetzungen insbesondere zur maschinellen Applikation auf Schiffsrümpfe und Schiffsaufbauten verwendet. Die Spachtelmassen sind zum einen scher- und kompressionsstabil und zum anderen zeigen sie das erforderliche Fließverhalten, so dass sie in entsprechenden Maschinen ohne Beeinträchtigung ihrer Eigenschaften verpumpt und ausgebracht werden können.

Weiterhin wird die der Erfindung zugrunde liegende Aufgabe durch ein Verfahren zur maschinellen Verarbeitung der Spachtelmassen gelöst. Bisher werden die im Yachtbau eingesetzten Spachtelmassen von Hand bzw. händisch verarbeitet. Dazu werden die Komponenten der Spachtelmasse im richtigen Mischungsverhältnis in einen Behälter gegeben und von Hand vermengt. Die gemischte Spachtelmasse wird dann in Eimern oder ähnlichen Behältnissen zur Arbeitsstelle am Schiff getragen. Dort wird die Spachtelmasse mit Kellen, Brettern, Spachteln oder Spateln von Hand auf die Schiffsaußenhülle aufgetragen und anschließend ebenfalls von Hand geglättet und verschlichtet. Nach der Aushärtung wird die Oberfläche der aufgetragenen Spachtelschicht auf Kontur geschliffen und/oder gefräst. Diese Verarbeitungsverfahren sind sehr arbeitsaufwendig und teuer. Darüber hinaus sind sie fehleranfällig. So führt die manuelle Vermischung der Komponenten in einem offenen Behälter zu Lufteinmischungen, die im ausgehärteten Spachtel Lufteinschlüsse bilden. Beim Schleifen werden diese Einschlüsse aufgeschliffen und verursachen Poren auf der Oberfläche, die wieder repariert werden müssen. Tiefer in der Spachtelschicht liegende Lufteinschlüsse, welche nicht entdeckt werden, sind Schwachstellen im Beschichtungsaufbau, die zu Schäden und Brüchen in der fertigen Lackierung des Schiffes führen können. Weiterhin kommt es bei der Applikation von Hand häufig zu großen Unterschieden in den aufgetragenen Schichtdicken, die durch Schleifen abgetragen und angeglichen werden müssen. Vor allem an den Stellen, an denen das Werkzeug neu angesetzt wird, werden Kanten gebildet, die durch Schleifen oder Fräsen abgetragen und angeglichen werden müssen. Da die bisher eingesetzten Spachtel sehr hart sind, ist das Schleifen und Fräsen mit einem entsprechend hohen Kraftaufwand verbunden.

Das erfindungsgemäße Verfahren zur maschinellen Verarbeitung der Spachtelmassen weist die folgenden Schritte auf:
(a) die Bindemittelkomponente und die Härterkomponente werden in eine Mischkammer gepumpt, wobei die Mengen so dosiert werden, dass das gewünschte Mischungsverhältnis erhalten wird,
(b) die beiden Komponenten werden in der Mischkammer zu einer Spachtelmasse gemischt,
(c) die Spachtelmasse wird aus der Mischkammer ausgetragen,
(d) die Spachtelmasse wird auf einen Untergrund aufgetragen,
(e) die aufgetragene Spachtelmasse wird zu einem Spachtel ausgehärtet,
(f) die Oberfläche des ausgehärteten Spachtels wird durch Schleifen oder Fräsen geglättet.

Im erfindungsgemäßen Verfahren eingesetzte Spachtelmassen weisen folgende Eigenschaften auf:
- Elastizitätsmodul (gemessen bei 23 °C) im Bereich von 500 bis 2100 MPa, bevorzugt 500 bis 1500 MPa;
- Bruchdehung (gemessen bei 23 °C) im Bereich von 0,3 bis 4 %, bevorzugt 2 bis 4 %;
- Zugfestigkeit (gemessen bei 23 C) im Bereich von 7 bis 17 MPa, bevorzugt 7 bis 15 MPA;
- Dichte im Bereich von 0,5 bis 1 g/cm³;
- linearer Wärmeausdehnungskoeffizient im Bereich von 0,5*10⁻⁹ bis 1,5*10⁻⁹ K⁻¹;
- Shore-D-Härte im Bereich von 60 bis 72, bevorzugt 60 bis 70;
- Glasübergangstemperatur im Bereich von 30 bis 45 °C.

Um eine möglichst ebene und glatte Oberfläche zu erhalten, können die Schritte (c) bis (f) gegebenenfalls mehrfach wiederholt werden. Weiterhin können unterschiedlich eingefärbte Bindemittelkomponenten und Härterkomponenten eingesetzt werden, um bei der Mischung der beiden Komponenten eine Anzeige für die Homogenität der Mischung zu haben.

In einer bevorzugten Ausführungsform wird die Spachtelmasse sowohl maschinell aus der Mischkammer ausgetragen als auch maschinell auf den Untergrund aufgetragen. Der Auftrag der Spachtelmassen kann beispielsweise durch Giessen, Ablegen von Raupen, hydraulisches oder Druckluft unterstütztes Zerstäuben erfolgen. Erfindungsgemäß bevorzugt werden die Spachtelmassen durch Zerstäuben appliziert. Zur Durchführung der erfindungsgemäßen Verfahren geeignete Anlagen sind beispielsweise die dem Fachmann bekannten und üblicherweise eingesetzten Airless-Spritzanlagen für zweikomponentige Systeme. In diesen Anlagen werden die Härter- und die Bindemittelkomponente unter hohen Drucken aus ihren jeweiligen Vorratsbehältern in die Mischkammer gepumpt und von dort unter hohem Druck durch eine Zerstäubungsdüse ausgetragen. Die Spritzanlagen arbeiten mit Drucken bis zu 600 bar. In der Regel wird bei Drucken zwischen 50 und 300 bar gearbeitet.

Eine erfindungsgemäße Spachtelmasse kann mit dem erfindungsgemäßen Verfahren erheblich schneller und gleichmäßiger aufgetragen werden als es von Hand möglich ist. Die Spachtelmasse wird dabei mit einer Schichtdicke von 0,5 bis 50 mm, bevorzugt von 1 bis 10 mm, besonders bevorzugt von 2 bis 5 mm, aufgetragen.

Das erfindungsgemäße Verfahren ist insbesondere geeignet zur Beschichtung von Schiffsrümpfen und Schiffsaufbauten. Es ist zum Bearbeiten von Untergründen aus den üblichen im Schiffsbau eingesetzten Materialien wie beispielsweise Metall, Holz und Faserverbundwerkstoffe geeignet.

Um das gewünschte Aussehen der Oberfläche zu erhalten, werden die nach dem erfindungsgemäßen Verfahren erhaltenen Oberflächen weiter mit den dem Fachmann bekannten und geläufigen Verfahren weiterbearbeitet. So wird beispielsweise die Oberfläche nach dem Schleifen und/oder Fräsen zunächst mit einem Feinspachtel abgezogen, um noch vorhandene Lufteinschlüsse und Poren zu schließen. Anschließend wird eine füllende Grundierung aufgetragen. Dann werden Decklacke oder farbgebende Basislacke appliziert, die mit Klarlacken beschichtet werden.

Die vorliegende Erfindung betrifft auch einen Schiffsrumpf, der mit dem erfindungsgemäßen Verfahren beschichtet wurde.

### Beispiele

**Beispiel 1: Erfindungsgemäße Rezeptur**

| **Bestandteil** | **Gew.-%** |
|---|---|
| **Bindemittelkomponente** | |
| Bisphenol A-Harz | 68,5 |
| Hexandioldiglycidylether | 9,3 |
| Talkum | 18,7 |
| pyrogene Kieselsäure | 1,9 |
| Kunststoffhohlkugeln | 1,6 |

| **Härterkomponente** | |
|---|---|
| handelsüblicher Epoxidharzhärter auf Basis von aliphatischen Aminen enthaltend | 66,4 |
| 30 Gew.-% Trimethylhexamethylendiamin | |
| Talkum | 26,6 |
| pyrogene Kieselsäure | 5,7 |
| Kunststoffhohlkugeln | 1,3 |

**Beispiel 2: Vergleichsrezeptur**

| **Bestandteil** | **Gew.-%** |
|---|---|
| Bindemittelkomponente | |
| Bisphenol A-Harz | 65,1 |
| Hexandioldiglycidylether | 8,9 |
| Talkum | 17,8 |
| pyrogene Kieselsäure | 1,8 |
| Glashohlkugeln | 6,5 |

| **Härterkomponente** | |
|---|---|
| handelsüblicher Epoxidharzhärter auf Basis von aliphatischen Aminen enthaltend mit 30 Gew.-% Trimethylhexamethylendiamin | 63,5 |
| Talkum | 25,4 |
| pyrogene Kieselsäure | 5,5 |
| Glashohlkugeln | 5,7 |

Die Bindemittel- und Härterkomponenten der Beispiele 1 und 2 wurden in einem molaren Mischungsverhältnis von 1 : 1 zu einer blasenfreien, homogenen Masse gemischt, dann per Hand auf einen Probekörper aufgetragen und 24 Stunden bei Raumtemperatur ausgehärtet. In einem ersten Versuch wurden Bindemittel- und Härterkomponente per Hand gemischt, in einem zweiten Versuch wurden die Komponenten maschinell mittels einer Bonsink Fillermixingmachine gemischt. Die Dichte des ausgehärteten Spachtels wird mit dem üblichen Pyknometer-Verfahren zur Dichtemessung von Festkörpern bestimmt. Die Ergebnisse sind in Tabelle 1 zusammengefasst.

**Tabelle 1:**

| | **Dichte der ausgehärteten Spachtels [g/cm³]** | |
|---|---|---|
| | handgemischt | maschinell gemischt |
| **Beispiel 1** | 0,82 | 0,86 |
| **Beispiel 2** | 0,92 | 1,14 |

## Patentansprüche

1. Verwendung einer Spachtelmasse aufweisend eine Bindemittelkomponente, welche ein oder mehrere Epoxidharze enthält, und eine Härterkomponente, welche ein oder mehrere NH-gruppenhaltige Verbindungen enthält, in maschinellen Verarbeitungsverfahren umfassend die Schritte (a) Dosieren der Komponenten, (b) Mischen der Komponenten zu einer Masse und (c) Applizieren der Masse auf einen Untergrund, **dadurch gekennzeichnet, dass** die Zusammensetzung zur Herstellung der Spachtelmasse 0,1 bis 15 Gew.-% Kunststoffhohlkörper bezogen auf Gesamtmenge der Zusammensetzung enthält.

2. Verwendung nach Anspruch 1, **dadurch gekennzeichnet, dass** die Kunststoffhohlkörper in der eingesetzten Spachtelmasse Hohlkugeln sind.

3. Verwendung nach Anspruch 1 oder 2, **dadurch gekennzeichnet, dass** die Kunststoffhohlkörper in der eingesetzten Spachtelmasse eine Dichte, bestimmt mit Hilfe eines Zweikammer-Pyknometer-Messgeräts, von 0,005 bis 0,8 g/cm³, bevorzugt 0,01 bis 0,5 g/cm³, besonders bevorzugt 0,02 bis 0,03 g/cm³ aufweisen.

4. Verwendung nach einem der voranstehenden Ansprüche, **dadurch gekennzeichnet, dass** die Epoxidharze der Bindemittelkomponente der eingesetzten Spachtelmasse ausgewählt sind aus der Gruppe enthaltend Glycidylether des Bisphenol A, Glycidylether des Bisphenol F, Glycidylether des Bisphenol A und F, Epoxid-Novolak-Harze und niederviskose Epoxidharze sowie deren Gemische.

5. Verwendung nach einem der voranstehenden Ansprüche, **dadurch gekennzeichnet, dass** die NH-gruppenhaltigen Verbindungen der Härterkomponente der eingesetzten Spachtelmasse ausgewählt sind aus der Gruppe enthaltend aliphatische und cycloaliphatische Amine, Amide, Amidoamine und aromatische Amine sowie deren Gemische.

6. Verwendung nach einem der voranstehenden Ansprüche, **dadurch gekennzeichnet, dass** die eingesetzte Spachtelmasse Bindemittelkomponente und Härterkomponente im molaren Verhältnis von 0,5 : 1,5 bezogen auf das Verhältnis von Epoxidgruppen zu aktiven Wasserstoffen der NH-Gruppen aufweist.

7. Verwendung der Spachtelmasse in maschinellen Verarbeitungsverfahren nach einem der voranstehenden Ansprüche, **dadurch gekennzeichnet, dass** der Verfahrensschritt (c) oder die Verfahrensschritte (b) und (c) mittels einer Maschine ausgeführt werden.

8. Verwendung der Spachtelmasse in maschinellen Verarbeitungsverfahren nach einem der voranstehenden Ansprüche zur Beschichtung von Schiffsrümpfen und/oder Schiffsaufbauten.

9. Verfahren zur maschinellen Verarbeitung von Spachtelmassen aufweisend eine Bindemittelkomponente, welche ein oder mehrere Epoxidharze enthält, und eine Härterkomponente, welche ein oder mehrere NH-gruppenhaltige Verbindungen enthält, wobei die Bindemittelkomponente und/oder die Härterkomponente 0,1 bis 15 Gew.-% Kunststoffhohlkörper bezogen auf Gesamtmenge der Zusammensetzung enthält, aufweisend die Schritte
(a) die Bindemittelkomponente und die Härterkomponente in einem ausgewählten Mischungsverhältnis in eine Mischkammer gepumpt werden,
(b) die beiden Komponenten in der Mischkammer zu einer Spachtelmasse gemischt werden,
(c) die Spachtelmasse aus der Mischkammer ausgetragen wird,
(d) die Spachtelmasse auf einen Untergrund aufgetragen wird,
(e) die aufgetragene Spachtelmasse zu einem Spachtel ausgehärtet wird,
(f) und die Oberfläche des ausgehärteten Spachtels geglättet wird.

10. Verfahren nach Anspruch 9, **dadurch gekennzeichnet, dass** auf die geschliffene Oberfläche weitere Beschichtungen oder Beschichtungssysteme aufgebracht werden.

11. Verfahren nach Anspruch 9 oder 10, **dadurch gekennzeichnet, dass** in Schritt (d) die Spachtelmasse mittels Zerstäubung auf den Untergrund aufgetragen wird.

12. Verfahren nach einem der Ansprüche 9 bis 11, **dadurch gekennzeichnet, dass** die Untergründe Schiffsrümpfe und/oder Schiffsaufbauten sind.

13. Schiffsrumpf mit Spachtelmassen beschichtet nach einem der Ansprüche 1 bis 8.

14. Zusammensetzung zur Herstellung einer Spachtelmasse, welche eine Bindemittelkomponente und eine Härterkomponente enthält, **dadurch gekennzeichnet, dass** die eingesetzte Spachtelmasse enthält
- 40 bis 95 Gew.-% Epoxidharze bezogen auf die Gesamtmasse der Bindemittelkomponente,
- 5 bis 70 Gew.-% NH-gruppenhaltige Verbindungen bezogen auf die Gesamtmasse der Härterkomponente und
- 0,1 bis 15 Gew.-% Kunststoffhohlkörper bezogen auf die Gesamtmasse der Spachtelmasse,
wobei die Kunststoffhohlkörper eine Dichte, bestimmt mit Hilfe eines Zweikammer-Pyknometer-Messgeräts, von 0,005 bis 0,8 g/cm³ aufweisen.

15. Zusammensetzung nach Anspruch 14, **dadurch gekennzeichnet, dass** die Bindemittelkomponente Glycidylether des Bisphenol A, Glycidylether des Bisphenol F oder deren Gemische aufweist und die Härterkomponente aliphatische oder cycloaliphatische Amine, Amide, Amidoamine oder deren Gemische aufweist.

## Claims

1. Use of a putty having a binder component, containing one or more epoxy resins, and a hardener component, including one or more NH-group-containing compounds, in mechanical processing methods comprising the steps (a) dosing the components, (b) mixing the components until a mass is obtained, and (c) applying the mass to an undercoat, **characterised in that** the composition for producing the putty contains 0.1 to 15 wt.-% of synthetic hollow bodies based on the total quantity of the composition.

2. Use according to claim 1, **characterised in that** the synthetic hollow bodies in the employed putty are hollow spheres.

3. Use according to claim 1 or 2, **characterised in that** the synthetic hollow bodies in the employed putty have a density, which is determined by means of a two-chamber pycnometer measuring device, of 0.005 to 0.8 g/cm³, preferably 0.01 to 0.5 g/cm³, more preferably 0.02 to 0.03 g/cm³.

4. Use according to one of the preceding claims, **characterised in that** the epoxy resins of the binder component of the employed putty are selected from the group containing glycidyl ether of bisphenol A, glycidyl ether of bisphenol F, glycidyl ether of bisphenol A and F, epoxy Novolac resins and low-viscosity epoxy resins as well as the mixtures thereof.

5. Use according to one of the preceding claims, **characterised in that** the NH-group-containing compounds of the hardener component of the employed putty are selected from the group containing aliphatic and cycloaliphatic amines, amides, amido amines and aromatic amines as well as the mixtures thereof.

6. Use according to one of the preceding claims, **characterised in that** the employed putty has a binder component and a hardener component in a molar ratio of 0.5:1.5 based on the ratio of epoxy groups to active hydrogens of the NH-groups.

7. Use of the putty in mechanical processing methods according to one of the preceding claims, **characterised in that** the process step (c) or the process steps (b) and (c) are carried out using a machine.

8. Use of putty in mechanical processing methods according to one of the preceding claims for coating hulls and/or ship superstructures.

9. Method of mechanical processing of putties comprising a binder component which contains one or more epoxy resins, and a hardener component which includes one or more NH-group-containing compounds, with the binder component and/or the hardener component containing 0.1 to 15 wt.-% of synthetic hollow bodies based on the total quantity of the composition, comprising the steps
(a) the binder component and the hardener component are pumped in a selected mixing ratio into a mixing chamber,
(b) both components are mixed in the mixing chamber to obtain a putty,
(c) the putty is extracted from the mixing chamber,
(d) the putty is applied to an undercoat,
(e) the coated putty is hardened to obtain a filler,
(f) and the surface of the hardened filler is smoothened.

10. Method according to claim 9, **characterised in that** additional coatings or coating systems are applied to the polished surface.

11. Method according to claim 9 or 10, **characterised in that** in step (d) the putty is applied to the undercoat by means of sputtering.

12. Method according to any one of claims 9 to 11, **characterised in that** the undercoats are hulls and/or ship superstructures.

13. Hull coated with putties according to any one of claims 1 to 8.

14. Composition for producing a putty which contains a binder component and a hardener component, **characterised in that** the employed putty contains:
- 40 to 95 wt.-% of epoxy resins based on the total mass of the binder component,
- 5 to 70 wt.-% of NH-group-containing compounds based on the total mass of the hardener component and
- 0.1 to 15 wt.-% of synthetic hollow bodies based on the total mass of the putty,
with the synthetic hollow bodies having a density, which is determined by means of a two-chamber pycnometer measuring device, of 0.005 to 0.8 g/ cm³.

15. Composition according to claim 14, **characterised in that** the binder component contains glycidyl ether of bisphenol A, glycidyl ether of bisphenol F or the mixtures thereof and that the hardener component contains aliphatic or cycloaliphatic amines, amides, amido amines or the mixtures thereof.

## Revendications

1. Utilisation d'un mastic - comprenant un composant liant qui contient une ou plusieurs résines époxy et un composant durcisseur qui contient un ou plusieurs composés comportant des groupes NH - dans des procédés de traitement mécanique comprenant les étapes (a) doser les composants, (b) mélanger les composants jusqu'à l'obtention d'une masse, et (c) appliquer la masse sur un substrat, **caractérisée en ce que** la composition pour la production du mastic contient de 0,1 à 15 % en poids de corps creux en matière plastique par rapport à la quantité totale de la composition.

2. Utilisation selon la revendication 1, **caractérisée en ce que** les corps creux en matière plastique contenus dans le mastic employé sont des sphères creuses.

3. Utilisation selon la revendication 1 ou 2, **caractérisée en ce que** les corps creux en matière plastique contenus dans le mastic employé ont une densité déterminée au moyen d'un pycnomètre à deux chambres de 0,005 à 0,8 g/cm³, de préférence de 0,01 à 0,5 g/cm³, ou mieux encore de 0,02 à 0,03 g/cm³.

4. Utilisation selon l'une des revendications précédentes, **caractérisée en ce que** les résines époxy du composant liant du mastic employé sont choisies dans le groupe contenant les éthers glycidyliques du bisphénol A, les éthers glycidyliques du bisphénol F, les éthers glycidyliques du bisphénol A et F, les résines époxy novolaques et les résines époxy de faible viscosité ainsi que leurs mélanges.

5. Utilisation selon l'une des revendications précédentes, **caractérisée en ce que** les composés comportant des groupes NH du composant durcisseur du mastic employé sont choisis dans le groupe contenant les amines aliphatiques et cycloaliphatiques, les amides, les amidoamines et les amines aromatiques ainsi que leurs mélanges.

6. Utilisation selon l'une des revendications précédentes, **caractérisée en ce que** le mastic employé contient un composant liant et un composant durcisseur dans le rapport molaire de 0,5 ; 1,5 par rapport à celui des groupes époxy aux hydrogènes actifs des groupes NH.

7. Utilisation du mastic dans des procédés de traitement mécanique selon l'une des revendications précédentes, **caractérisée en ce que** l'étape de procédé (c) ou les étapes de procédé (b) et (c) est/sont effectuée(s) au moyen d'une machine.

8. Utilisation du mastic dans des procédés de traitement mécanique selon l'une des revendications précédentes pour le revêtement de coques et/ou de superstructures de navire.

9. Procédé de traitement mécanique de mastics comprenant un composant liant qui contient une ou plusieurs résines époxy et un composant durcisseur qui contient un ou plusieurs composés comportant des groupes NH, le composant liant et/ou le composant durcisseur ayant 0,1 à 15 % en poids de corps creux en matière plastique par rapport à la quantité totale de la composition, comprenant les étapes suivantes
(a) le composant liant et le composant durcisseur sont pompés dans une chambre de mélange dans un rapport de mélange sélectionné,
(b) les deux composants sont mélangés dans la chambre de mélange jusqu'à l'obtention d'un mastic,
(c) le mastic est extrait de la chambre de mélange,
(d) le mastic est appliqué sur un substrat,
(e) le mastic appliqué est durci jusqu'à l'obtention d'un bouche-pores,
(f) et la surface du bouche-pores durci est lissée.

10. Procédé selon la revendication 9, **caractérisé en ce que** d'autres revêtements ou systèmes de revêtement sont appliqués sur la surface lissée.

11. Procédé selon la revendication 9 ou 10, **caractérisé en ce que**, dans l'étape (d), le mastic est appliqué sur le substrat par pulvérisation.

12. Procédé selon l'une quelconque des revendications 9 à 11, **caractérisé en ce que** les substrats sont des coques et/ou des superstructures de navire.

13. Coque revêtue de mastics selon l'une quelconque des revendications 1 à 8.

14. Composition pour la production d'un mastic contenant un composant liant et un composant durcisseur, **caractérisée en ce que** le mastic employé contient
- 40 à 95 % en poids de résines époxy par rapport à la masse totale du composant liant,
- 5 à 70 % en poids de composés comportant des groupes NH par rapport à la masse totale du composant durcisseur
et
- 0,1 à 15 % en poids de corps creux en matière plastique par rapport à la masse totale du mastic, les corps creux en matière plastique ayant une densité déterminée au moyen d'un pycnomètre à deux chambres de 0,005 à 0,8 g/cm³.

15. Composition selon la revendication 14, **caractérisée en ce que** le composant liant contient des éthers glycidyliques du bisphénol A, des éthers glycidyliques du bisphénol F ou leurs mélanges et que le composant durcisseur contient des amines aliphatiques ou cycloaliphatiques, des amides, des amidoamines ou leurs mélanges
